# EUROPÄISCHE PATENTANMELDUNG

(11) **EP 2 464 204 A1**
(43) Veröffentlichungstag der Anmeldung: **13.06.2012**
(21) Anmeldenummer: 10194303.3
(22) Anmeldetag: 09.12.2010
(51) Int. Cl.: H05K 5/02, G05B 23/02, G08B 13/24, H05K 7/14

(54) **Verfahren zum Ermitteln von Geräteinformationen von in einem Schaltschrank eingebauten Geräten**

(71) Anmelder: SIEMENS AKTIENGESELLSCHAFT, 80333 München (DE)
(72) Erfinder: Bachfischer, Norbert, 92245, Kümmersbruck (DE); Gutsche, Achim, 90559, Ezelsdorf (DE); Mosburger, Ulrich, 92262, Birgland (DE)

(57) **Zusammenfassung**

Die Erfindung betrifft ein Verfahren sowie ein System zum Ermitteln von Geräteinformationen von in einem Schaltschrank (1) eingebauten Geräten (3). Um das Ermitteln von Geräteinformationen von in dem Schaltschrank (1) eingebauten Geräten (3) zu verbessern wird vorgeschlagen, dass mindestens zwei Geräte (3) in dem Schaltschrank (1) eingebaut sind, welche jeweils einen maschinenlesbaren Code (4) aufweisen, wobei der maschinenlesbare Code (4) eine Geräteinformation des jeweiligen Geräts (3) abbildet, und folgende Schritte durchgeführt werden: Auslesen der Geräteinformationen aus den Codes (4) der mindestens zwei eingebauten Geräte (3) und Hinterlegen der ausgelesenen Geräteinformationen in einem Speicher.

## Beschreibung

Die Erfindung betrifft ein Verfahren sowie ein System zum Ermitteln von Geräteinformationen von in einem Schaltschrank eingebauten Geräten.

Im Bereich der industriellen Automatisierungstechnik werden häufig elektrische Geräte zu ihrem Schutz sowie zum Schutz der Umgebung in einem Schaltschrank verbaut. Der Schaltschrank beherbergt hierbei die elektrischen und/oder elektronischen Geräte einer verfahrenstechnischen Anlage, einer Werkzeugmaschine oder einer Fertigungseinrichtung, die sich nicht direkt in der Maschine (wie z. B. Sensoren) befinden. Im einfachsten Fall enthält der Schaltschrank nur Klemmen zum übersichtlichen elektrischen Verbinden verschiedener Geräte einer Anlage (Klemmkasten, Verteilerkasten). Bei einem geschlossenen Schaltschank ist die zufällige und unbeabsichtigte Berührung spannungsführender Bauteile ausgeschlossen. Schaltschränke, die im Inneren berührbare Teile mit gefährlichen Spannungen enthalten, sind meist nur mit Werkzeugen (Schaltschrankschlüssel, Drei- oder Vierkantschlüssel) zu öffnen. Der Schaltschrank bietet insbesondere für die Geräte im Innenraum einen Schutz vor Staub und Wasser, eine Halterung (z.B. mittels einer Tragschiene, Montageplatte), eine Möglichkeit zur strukturierten Anordnung (z.B. Unterteilung in Leistungs- und Steuerungsbereiche), einen Schutz vor Überhitzung (z.B. durch eine Schaltschrankklimatisierung), einen Schutz vor Elektromagnetischer Beeinflussung (EMV) und/oder einen Schutz gegen mechanische Einflüsse (z.B. Vandalismus, Erdbeben). Ferner bietet der Schaltschrank hinsichtlich der im Schaltschrank verbauten Geräte für die Umgebung insbesondere eine Abschirmung vor elektromagnetischen Emissionen, einen Schutz gegen das Berühren gefährlicher Spannungen und/oder einen Brandschutz.

Viele Schaltschränke besitzen des weiteren außen einen Not-Aus-Taster und/oder einen geeigneten Hauptschalter zur Stilllegung der zugehörigen Maschine im Gefahrenfall.

Bei der Installation des Schaltschranks werden zunächst hinsichtlich der zu betreibenden Anlage die erforderlichen Geräte in dem Schaltschrank verbaut. Die einzelnen im Schaltschrank verbauten/eingebauten Geräte können derzeit nur durch manuelles Aufschreiben erfasst und dokumentieret werden. Hierfür muss ein Installateur das jeweilige Gerätemodell am Typschild des Gerätes ablesen und in einer Liste eintragen. Das korrekte Ablesen und Vermerken des jeweiligen Gerätemodells der verbauten Geräte von den jeweiligen Typschildern unterliegt einem Fehlerpotential, da zum einem die Gerätemodelle auf den Typschildern meist in sehr kleiner Schrift vermerkt sind und zum Anderen dem Installateur während des Ablesens und Eintragens in seiner Liste ein Fehler unterlaufen kann. Ferner beansprucht dieser Vorgang eine kostspielige Arbeitszeit des Installateurs.

Es ist Aufgabe der vorliegenden Erfindung das Ermitteln von Geräteinformationen von in einem Schaltschrank eingebauten Geräten zu verbessern.

Vorzugsweise erfolgt ferner ein verbessertes Ausnutzen der Geräteinformationen von in dem Schaltschrank eingebauten Geräten.

Diese Aufgabe wird gelöst durch ein Verfahren gemäß Anspruch 1, d.h. durch ein Verfahren zum Ermitteln von Geräteinformationen von in einem Schaltschrank eingebauten Geräten, wobei mindestens zwei Geräte in dem Schaltschrank eingebaut sind, welche jeweils einen maschinenlesbaren Code aufweisen, wobei der maschinenlesbare Code eine Geräteinformation des jeweiligen Geräts abbildet, mit folgenden Schritten:
- Auslesen der Geräteinformationen aus den Codes der mindestens zwei eingebauten Geräte und Hinterlegen der ausgelesenen Geräteinformationen in einem Speicher, und einer Vorrichtung gemäß Anspruch 14, d.h. durch ein System, welches ein Lesegerät, einen Schaltschrank, mindestens zwei Geräte, welche jeweils einen maschinenlesbaren Code aufweisen und in dem Schaltschrank eingebaut sind, ein Ausgabemittel und eine Recheneinheit umfasst, wobei das System dazu ausgebildet ist das Verfahren nach einem der Ansprüche 1 bis 13 durchzuführen, sowie durch ein Computerprogrammprodukt enthaltend Programmcodemittel zur Ausführung eines Verfahrens nach einem der Ansprüche 1 bis 13, wenn besagtes Computerprogrammprodukt auf einem Datenverarbeitungssystem ausgeführt wird.

Vorteilhafte Weiterbildungen der Erfindung sind in den abhängigen Ansprüchen 2 bis 13 angegeben.

Der erfindungsgemäße Schaltschrank ist insbesondere ein Schaltschrank, welcher im Umfeld der industriellen Automatisierungstechnik eingesetzt wird. In diesem Schaltschrank können vorzugsweise Steuerungen, Netzteile, Leistungsschalter, Schütze und/oder andere elektrische Geräte eingebaut werden. Vorzugsweise ermöglicht eine Hutschiene (Tragschiene) einen vereinfachten Einbau dieser Geräte innerhalb des Schaltschranks. Die Verkabelung der Geräte untereinander erfolgt vorzugsweise innerhalb des Schaltschrankes.

Wird nun beispielsweise eine Neuinstallation einer Anlage betrachtet, so werden zunächst die für die Anlage notwendigen Geräte in einen Schaltschrank durch einen Installateur eingebaut. Diese eingebauten Geräte weisen vorzugsweise alle einen maschinenlesbaren Code auf. Über den maschinenlesbaren Code des jeweiligen Gerätes wird eine Geräteinformation des jeweiligen Gerätes abgebildet. Nachdem oder bereits während der Installation können nun die Codes der jeweiligen Geräte ausgelesen und in einem Speicher hinterlegt werden, so dass in dem Speicher die einzelnen Geräteinformationen der im Schaltschrank eingebauten Geräte vorliegen. Der Installateur oder ein anderer Benutzer kann nun anhand der im Speicher hinterlegten Geräteinformationen genau erkennen welche Geräte in dem Schaltschrank verbaut sind. Ferner kann anhand der hinterlegten Geräteinformationen eine intelligente Auswertung hinsichtlich der im Schaltschrank verbauten Geräte erfolgen.

Wird beispielsweise das Gerätemodell durch den maschinenlesbaren Code abgebildet, so kann das aufwendige manuelle Ablesen und Abschreiben der Gerätemodelle der verbauten Geräte entfallen, da diese Information bereits durch die ausgelesenen Geräteinformationen im Speicher hinterlegt sind. Anhand dieser hinterlegten Geräteinformationen der Geräte kann nun beispielsweise mit einer weiterverarbeitenden Einheit (z.B. mittels einer Recheneinheit, welche eine Projektierungssoftware umfasst) eine Liste hinsichtlich der im Schaltschrank verbauten Geräte und insbesondere der verbauten Gerätemodelle erstellt werden. Eine lückenlose durchgängige Dokumentation der im Schaltschrank eingebauten Geräte kann somit auf einfache Weise erfolgen, wobei gleichzeitig die korrekte Erfassung der im Schaltschrank verbauten Gerätemodelle gewährleistet werden kann.

Die Gefahr eines falschen Ablesens und/oder Eintragens hinsichtlich der im Schaltschrank verbauten Geräte bei einer herkömmlichen Bestandaufnahme durch einen Installateur kann somit vermieden werden. Insbesondere kann eine zuverlässige, einfache und schnelle Sicherstellung einer Anlagendokumentation erfolgen. Dem Installateur kann Arbeit abgenommen werden, was wiederum zu einer Einsparung von Kosten führt.

In einer vorteilhaften Ausführungsform der vorliegenden Erfindung bildet zumindest ein Teil der Geräteinformation des Geräts eine Geräteseriennummer, ein Gerätemodell und/oder eine Fertigungsidentifikation des jeweiligen Geräts ab. Die Geräteseriennummer ist vorzugsweise eine einmalig vergebene Seriennummer hinsichtlich des Gerätemodells. Das Gerätemodell gibt vorzugsweise das genaue Modell des Geräts an. Das Gerätemodell wäre beispielsweise bei den Produkten der Firma Siemens AG mit der maschinenlesbaren Fabrikantenbezeichnung (MLFB) gleich zu setzten. Die Fertigungsidentifikation umfasst insbesondere eine Angabe zum Fertigungsort und/oder eine Angabe zum Fertigungsdatum.

Bildet beispielsweise ein Teil der Geräteinformation des jeweiligen Gerätes das Gerätemodell des Geräts ab, so können über die ausgelesenen Geräteinformationen die einzelnen Gerätemodelle der verbauten Geräte ermittelt werden. Nach Fertigstellung des Schaltschrankes, d.h. nach dem Einbau der einzelnen Geräte in den Schaltschrank, kann somit eine Schaltschrank-Ist-Stückliste erstellt werden. Die Schaltschrank-Ist-Stückliste gibt die einzelnen Gerätemodelle der im Schaltschrank verbauten Geräte wieder. Auf diese Weise wird die Dokumentation für einen Installateur erheblich erleichtert, da im Speicher die Geräteinformationen der verbauten Geräte hinterlegt sind und somit beispielsweise auf einfache Weise eine Generierung der Schaltschrank-Ist-Stückliste erfolgen kann.

Umfasst die Geräteinformation beispielsweise die Geräteseriennummer, so wird hierdurch eine durchgängige Dokumentation der eingebauten Geräte auf Unikatsebene ermöglicht. Weitere nützliche Analysen können anhand dieser Informationen erfolgen (z.B. Analysen zum Plagiatschutz).

In einer weiteren vorteilhaften Ausführungsform der vorliegenden Erfindung umfasst das Verfahren ferner folgenden Schritt:
- Ausgeben mindestens eines Teils der hinterlegten Geräteinformationen über ein Ausgabemittel.

Das Ausgabemittel ist beispielsweise ein Bildschirm, über welchen die Geräteinformationen der jeweiligen Geräte angezeigt werden können. Beispielsweise umfasst ein Rechenmaschine (z.B. Laptop) den Speicher und das Ausgabemittel ist der zugehörige Bildschirm der Rechenmaschine. Mittels eines geeigneten Engineering Tools kann sich nun beispielsweise ein Anwender Geräteinformationen zu den im Schaltschrank verbauten Geräten anzeigen lassen. Ebenso könnte mittels des Engineering Tools beispielsweise eine Analyse hinsichtlich der verbauten Geräte erfolgen, so dass beispielsweise kontrolliert werden kann, ob alle erforderlichen Geräte verbaut sind. Das Ausgabemittel kann beispielsweise ebenso ein Drucker sein, über welchen mindestens ein Teil der Geräteinformationen ausgebbar ist.

Vorzugsweise kann mittels eines Engineering Tools auf den Speicher zugegriffen werden, so dass die dort hinterlegten Geräteinformationen derart aufbereitet werden können, so dass die erwünschte Information der Geräteinformationen am Ausgabemittel ausgegeben werden kann.

In einer weiteren vorteilhaften Ausführungsform der vorliegenden Erfindung wird anhand der im Speicher hinterlegten Geräteinformationen eine Schaltschrank-Ist-Stückliste gebildet, welche über das Ausgabemittel ausgebbar ist. Die Schaltschrank-Ist-Stückliste bildet die im Schaltschrank eingebauten Geräte, deren Code ausgelesen wurde, ab. Vorzugsweise wird hierbei das jeweilige Gerätemodell abgebildet.

In einer weiteren vorteilhaften Ausführungsform der vorliegenden Erfindung wird bei einem Entfernen eines eingebauten Gerätes, dessen Geräteinformation ausgelesen wurde, aus dem Schaltschrank mindestens ein Teil der Geräteinformation des entfernten Gerätes über das Ausgabemittel ausgegeben. Über das Ausgabemittel kann somit gezielt ausgegeben werden, welches Gerät entfernt wurde uns somit ggf. zu ersetzten ist. Dies stellt eine enorme Erleichterung für deinen Nutzer dar.

In einer weiteren vorteilhaften Ausführungsform der vorliegenden Erfindung umfasst das Verfahren ferner folgenden Schritt:
- Vergleichen mindestens eines Teils der hinterlegten Geräteinformationen mit mindesten einem Referenzwert.

Hierbei könnte beispielsweise ein Teil der Geräteinformation des jeweiligen Gerätes das Gerätemodell des Geräts abbilden.

Über die ausgelesenen Geräteinformationen können folglich die einzelnen Gerätemodelle der verbauten Geräte ermittelt werden. Eine Schaltschrank-Ist-Stückliste kann somit erstellt werden. Über einen geeigneten Referenzwert kann nun beispielsweise abgeglichen werden, ob die korrekten Geräte im Schaltschrank verbaut sind (z.B. stimmen die einzelnen eingebauten Geräte zueinander überein oder stimmen die eingebauten Geräte hinsichtlich einer erwünschten Funktionalität der im Schaltschrank verbauten Geräte überein). Ebenso könnte beispielsweise mittels eines geeigneten Referenzwerts eine Analyse bezüglich einer erwünschten Funktionalität der im Schaltschrank verbauten Geräte erfolgen. Hierfür könnte die Schaltschrank-Ist-Stückliste mit einer erforderlichen Schaltschrank-Soll-Stückliste, welche die erwünschte Funktionalität widerspiegelt, verglichen werden, so dass beispielsweise bei einem Abweichen darauf hingewiesen werden kann, welche Geräte gegenüber der Schaltschrank-Soll-Stückliste fehlen. Die Schaltschrank-Soll-Stückliste würde die erwünschte "Geräte-Besetzung" des Schaltschranks abbilden.

Ebenso könnte beispielsweise ein Teil der Geräteinformation des jeweiligen Gerätes für Sicherheitszwecke verwendet werden, so dass durch einen Vergleich des Teils der hinterlegten Geräteinformationen bzw. des Teils der Geräteinformation des jeweiligen Gerätes mit einem Referenzwert überprüft werden kann, ob ein Originalgerät oder eine Fälschung vorliegt. Eine Plagiatsüberprüfung kann somit erfolgen. Eine derartige Plagiatsüberprüfung könnte beispielsweise über die Geräteseriennummer erfolgen, da diese nur einmal vorliegen dar. Ein Referenzwert würde somit beispielsweise die verfügbaren Geräteseriennummern abbilden, so dass mittels des Referenzwertes kontrolliert werden kann ob diese Geräteseriennummer bereits verwendet wird oder nicht. Ebenso könnte beispielsweise anhand eines geeigneten Sicherheitscodes in der Geräteinformation eines Gerätes eine Plausibilitätsüberprüfung mit einem geeigneten Referenzwert erfolgen, so dass Plagiate erkannt werden können.

Ergibt der Vergleich mit dem mindestens einem Referenzwert, dass ein Fehler vorliegt (z.B. Schaltschrank-Ist-Stückliste stimmt nicht mit der Schaltschrank-Soll-Stückliste überein), so wird vorzugsweise ein Fehlersignal ausgegeben.

In einer weiteren vorteilhaften Ausführungsform der vorliegenden Erfindung wird anhand der hinterlegten Geräteinformationen eine Schaltschrank-Ist-Stückliste gebildet, wobei die Schaltschrank-Ist-Stückliste mit einer Schaltschrank-Soll-Stückliste verglichen wird und ein Signal ausgegeben wird, sofern die Schaltschrank-Ist-Stückliste nicht mit der Schaltschrank-Soll-Stückliste übereinstimmt. Die Schaltschrank-Soll-Stückliste bildet somit einen Referenzwert, welcher mit der Schaltschrank-Ist-Stückliste verglichen wird. Die Schaltschrank-Soll-Stückliste kann vorzugsweise durch den Anwender selbst erzeugt und somit zusammengestellt werden. Die Schaltschrank-Soll-Stückliste bildet insbesondere die Geräte ab, welche für den erwünschten Schaltschrankeinbau vorgesehen sind.

In einer weiteren vorteilhaften Ausführungsform der vorliegenden Erfindung wird bei einem Austauschen eines alten eingebauten Gerätes, dessen Geräteinformationen ausgelesen wurden, mit einem neuen Gerät, welches einen maschinenlesbaren Code aufweist, die Geräteinformation aus dem Code des neuen eingebauten Gerätes ausgelesen und mit der hinterlegten Geräteinformation des alten ausgetauschten Gerätes verglichen. Hierbei wird insbesondere ein Vergleich hinsichtlich des Gerätemodells der beiden Geräte durchgeführt. Auf diese Weise kann überprüft werden, ob ein richtiges neues Gerät eingebaut wurde. Vorzugsweise wird, sofern ein das neue verbautes Gerät nicht mit dem alten verbauten Geräte übereinstimmt ein Signal über ein Ausgabemittel ausgegeben (akustisches oder optisches Warnsignal).

In einer weiteren vorteilhaften Ausführungsform der vorliegenden Erfindung sind die mindestens zwei Geräte jeweils elektrische Schaltgeräte. Das im Schaltschrank eingebaute elektrische Schaltgerät ist vorzugsweise unter anderem ein Leistungsschalter, ein Schütz und/oder eine Steuerung.

In einer weiteren vorteilhaften Ausführungsform der vorliegenden Erfindung ist der maschinenlesbare Code insbesondere ein RFID Transponder, ein 1D Barcode oder ein 2D Barcode. Der RFID Transponder ist insbesondere ein aktiver oder passiver RFID Transponder. Der 1D Barcode ist beispielsweise ein Strichcode. Der 2D Barcode ist beispielsweise ein DataMatrix Code.

Vorzugsweise ist der maschinenlesbare Code jeweils auf der Gehäusefront der mindestens zwei Geräte platziert. Die Gehäusefront bildet insbesondere die im eingebauten Zustand des Gerätes im Schaltschrank zugängliche und sichtbare Seite des Gerätes.

In einer weiteren vorteilhaften Ausführungsform der vorliegenden Erfindung werden die Geräteinformationen der maschinenlesbaren Codes durch ein Lesegerät ausgelesen. Ist der maschinenlesbare Code ein RFID Transponder so ist das Lesegerät ein RFID Transceiver. Ist der maschinenlesbare Code ein Barcode, so ist das Lesegerät ein Barcodelesegerät.

Das Lesegerät kann ein stationäres Lesegerät oder ein Handlesegerät sein.

In einer weiteren vorteilhaften Ausführungsform der vorliegenden Erfindung umfasst der Schaltschrank das Lesegerät. Das Lesegerät ist vorzugsweise derart im Schaltschrank verbaut, so dass das Lesegerät selbstständig die maschinenlesbaren Codes auslesen kann. Über den Schaltschrank kann somit automatisch ein Auslesen der maschinenlesbaren Codes erfolgen, ohne dass ein Installateur das Lesegerät zu den einzelnen Geräten des Schaltschranks zuführen muss. Der Schaltschrank umfasst vorzugsweise ebenso den Speicher.

In einer weiteren vorteilhaften Ausführungsform der vorliegenden Erfindung umfasst eine Recheneinheit den Speicher. Die Recheneinheit umfasst vorzugsweise ferner eine Verarbeitungseinheit. Vorzugsweise ist in der Recheneinheit und insbesondere im Speicher der mindestens einen Referenzwert hinterlegt. Vorzugsweise erfolgt der Vergleich eines Teils der hinterlegten Geräteinformationen mit mindesten einem Referenzwert durch die Verarbeitungseinheit.

Durch ein derartiges System, welches ein Lesegerät, einen Schaltschrank, mindestens zwei Geräte, welche jeweils einen maschinenlesbaren Code aufweisen und in dem Schaltschrank eingebaut sind, ein Ausgabemittel und eine Recheneinheit umfasst, kann insbesondere ein verbessertes Ermitteln von Geräteinformationen von in einem Schaltschrank eingebauten Geräten erfolgen. Ein händisches zeitaufwändiges Abschreiben seitens des Installateurs kann somit entfallen. Ferner können Fehler vermieden und Kosten eingespart werden. Des Weiteren können durch die im Speicher hinterlegten Geräteinformationen neue Funktionalitäten für den Schaltschranknutzer aber auch für den Systemanbieter erstellt werden, so dass eine verbesserte Prozesslandschaft seitens der Schaltschranktechnik gebildet werden kann.

Insbesondere kann durch eine intelligente Auswertung der im Speicher hinterlegten Geräteinformationen einem Nutzer neue Analysemöglichkeiten angeboten werden (Vergleich der Schaltschrank-Ist-Stückliste mit der Schaltschrank-Soll-Stückliste, Dokumentation der verbauten Geräte, Austausch eines Gerätes, etc.).

Des Weiteren wird ein Computerprogrammprodukt, enthaltend Programmcodemittel zur Ausführung einer Ausführungsform des erfindungsgemäßen Verfahrens, beansprucht, wenn besagtes Computerprogrammprodukt auf einem Datenverarbeitungssystem ausgeführt wird. Das Computerprogrammprodukt ist vorzugsweise als Engineering Tool für einen Anwender an einer Rechenmaschine sichtbar. Mittels des Engineering Tools können einem Anwender vorzugsweise Teile der Geräteinformationen optisch visualisiert werden.

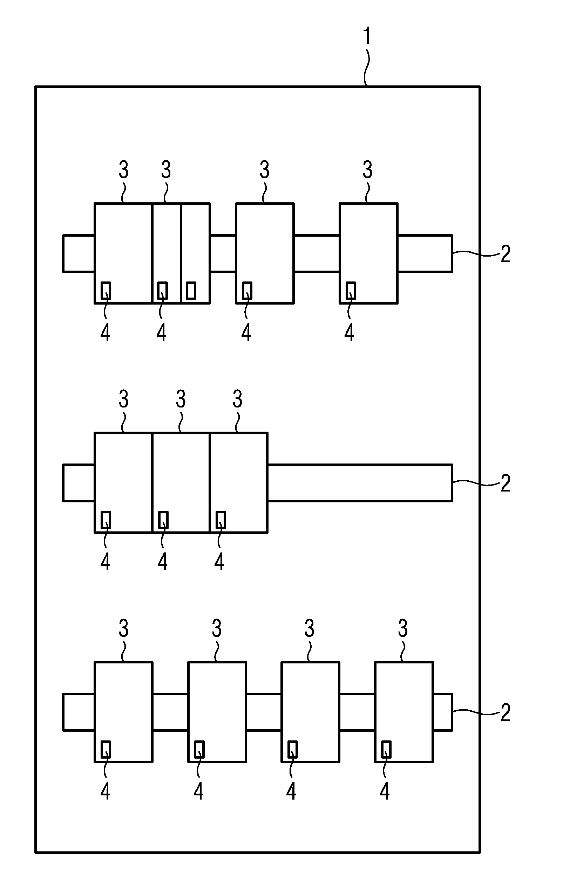

Im Folgenden werden die Erfindung und Ausgestaltungen der Erfindung anhand des in der Figur dargestellten Ausführungsbeispiels näher beschrieben und erläutert. Es zeigt:

Die Figur eine schematische Darstellung eines Schaltschranks, in welchem Geräte, welche einen maschinenlesbaren Code umfassen, eingebaut sind.

Die Figur zeigt eine schematische Darstellung eines Schaltschranks 1, in welchem Geräte 3, welche einen maschinenlesbaren Code 4 umfassen, eingebaut sind. Der Schaltschrank 1 weist zum Einbau der Geräte 3 drei Hutschienen 2 auf. Ein Installateur kann somit ein Gerät 3 leicht auf einer der Hutschienen 2 im Schaltschranks 1 befestigen und somit einbauen. Die Figur zeigt eine frontale Sicht in den geöffneten Schaltschrank 1. Es ist ersichtlich, dass die Geräte 3 jeweils auf ihrer Frontseite, d.h. der im eingebauten Zustand sichtbaren Seite, den maschinenlesbaren Code 4 aufweisen. Der maschinenlesbare Code 4 kann ein RFID-Transponder oder ein Barcode sein. Im vorliegenden Fall ist er ein Barcode, insbesondere ein Data-Matrix-Code (2D-Barcode). Der maschinenlesbare Code 4 bildet eine Geräteinformation des jeweiligen Geräts 3 ab. Insbesondere wird durch den maschinenlesbaren Code 4 eine Geräteseriennummer, ein Gerätemodell und eine Fertigungsidentifikation des jeweiligen Gerätes 3 abgebildet.

Nach einer Installation der notwendigen Geräte 3 in dem Schaltschrank 1 kann somit ein Installateur die einzelnen maschinenlesbaren Codes 4 der einzelnen Geräte 3 auslesen. Dies erfolgt vorzugsweise mittels eines nicht abgebildeten Lesegerätes durch ein einzelnes abscannen der Codes 4 der jeweiligen Geräte 3. Durch das Abscannen mittels des Lesegerätes erfolgt das Auslesen der Geräteinformation aus dem maschinenlesbaren Code 4 der einzelnen Geräte 3. Es ist ebenso denkbar, dass durch eine einmalige Aufnahme der Frontseite des Schaltschranks 1 und somit der verbauten Geräte 3 die einzelnen Codes 4 ermittelt und letztendlich ausgelesen werden können. Das Lesegerät ist mit einer nicht abgebildeten Recheneinheit, welche einen Speicher umfasst, verbunden, so dass beim Auslesen der Geräteinformation aus dem Code 4 der einzelnen Geräte 3 die jeweilige Geräteinformation des Codes 4 in dem Speicher hinterlegt werden kann. Nach einem vollständigen Abscannen der maschinenlesbaren Codes 4 der Geräte 3 sind somit die Geräteinformationen der Geräte 3 im Speicher hinterlegt. Ein manuelles Aufschreiben Erfassen und Dokumentieren der im Schaltschrank verbauten Geräte kann somit entfallen, da durch Zugriff auf die im Speicher hinterlegten Geräteinformationen die notwendigen Daten der verbauten Geräte (Gerätemodell, Geräteseriennummer, Fertigungsidentifikation) vorliegen. Durch Zugriff auf die im Speicher hinterlegten Geräteinformationen kann somit Ausleitung dieser Geräteinformationen oder eine weiterführende vorteilhafte intelligente Auswertung dieser Geräteinformationen erfolgen.

Die Recheneinheit kann beispielsweise ein Laptop sein. Durch ein Computerprogrammprodukt (z.B. Engineering Tool) der Recheneineinheit kann auf die im Speicher hinterlegten Geräteinformationen zugegriffen werden, so dass die Geräteinformationen weiterverarbeitet werden können. Ein Ausgabemittel ist ferner mit der Recheneinheit verbunden. Das Ausgabemittel ist beispielsweise ein Bildschirm der Recheneinheit, so dass über das Ausgabemittel Informationen dargestellt werden können. Die Recheneinheit kann somit auf die im Speicher hinterlegten Geräteinformationen der verbauten Geräte 3 zugreifen und diese mittels des Computerprogrammprodukts, insbesondere Engineering Tools, analysieren und am Bildschirm anzeigen. Ein Ausgabemittel kann ferner ein Drucker sein, welcher mit dem Rechenmittel verbunden ist, so dass Teile der Geräteinformationen ausgedruckt werden können. Es kann beispielsweise nach einer durchgeführten Installation der Geräte 3 im Schaltschrank eine Schaltschrank-Ist-Stückliste ausgeleitet werden. Ebenso kann, sofern der Speicher, insbesondere die Recheneinheit, mit einem übergeordneten System verbunden ist, durch das übergeordnete System auf die im Speicher hinterlegten Geräteinformationen zugegriffen werden. Auf einer übergeordneten Steuerungsebene können somit diese Geräteinformationen ebenso für Analysezwecke verwendet werden.

Mittels des Computerprogrammprodukts können somit mehrere Auswertungen hinsichtlich der eingebauten Geräte 3 im Schaltschrank 1 erfolgen. Es kann beispielsweise eine Schaltschrank-Ist-Stückliste erstellt werden. Eine Schaltschrank-Ist-Stückliste gibt vorzugsweise die Gerätemodelle aller verbauten Geräte 3 sowie deren Anzahl wieder. Diese Schaltschrank-Ist-Stückliste kann beispielsweise zur Dokumentation ausgedruckt oder in einer Datenbank hinterlegt werden. Ein lästiges manuelles Abschreiben der Gerätemodelle der verbauten Geräte von deren Typschildern kann somit entfallen.

Neben dem reinen Ausleiten der Geräteinformationen können die Geräteinformationen aber auch für weitere Analysezwecke analysiert werden. Hierbei erfolgt insbesondere eine Analyse der im Speicher hinterlegten Geräteinformationen gegenüber mindestens einem Referenzwert. Es kann beispielsweise mittels des Computerprogrammprodukts die Schaltschrank-Ist-Stückliste mit einer Schaltschrank-Soll-Stückliste (Referenzwert, welcher den ordnungsgemäßen Einbau der Geräte 3 im Schaltschrank 1 widerspiegelt) verglichen werden. Fehler beim Schaltschrankgeräteeinbau können hierdurch entdeckt und vermieden werden. Ebenso können beispielsweise die eingebauten Geräte automatisch vom internen Lager abgebucht werden. Zu jedem eingebauten Gerät 3 werden mittels der Geräteinformation ferner seine Geräteseriennummer und seine Fertigungsidentifikation angezeigt, welche zu Analyse- und/oder Dokumentationszwecken im Speicher hinterlegt sind. Somit kann beispielsweise überprüft werden, ob die Geräteseriennummer mehrfach existiert. Liegt dies vor, so handelt es sich möglicherweise um ein Plagiat.

Mittels des Computerprogrammprodukts können durch Zugriff auf eine weitere Datenbank ebenso weitere Informationen der im Schaltschrank eingebauten Geräte angezeigt oder für Analysezwecke verwendet werden. Hierdurch kann eine verbesserte Informationsversorgung hinsichtlich der verbauten Geräte erfolgen.

Mittels der im Speicher hinterlegten Geräteinformationen ergibt sich für einen Anwender eine Vielzahl von Zusatznutzen. Es kann beispielsweise bei einem Defekt eines eingebauten Gerätes 3 auf einfache Weise explizit ermittelt werden, welches Gerät 3 verbaut wurde, so dass ein gezielter Austausch erfolgen kann. Bei dem Austausch kann beispielweise überprüft werden, ob das neue eingebaute Gerät 3 die Funktionen des alten Gerätes 3 "übernehmen" kann, so dass ein ordnungsgemäßer Austausch vorliegt.

Durch die im Speicher hinterlegten Geräteinformationen kann ferner eine Analyse der im Schaltschrank verbauten Geräte auf Unikatsebene über eine Geräteseriennummer erfolgen.

Der Schaltschrankbau beim Anwender (vor allem Schaltschrank/Schaltanlagenbauer) kann somit durch entsprechende Codierung der Automatisierungskomponenten und einer entsprechenden funktionalen Erweiterung seines Engineering Tools (seiner Projektierungssoftware) deutlich effizienter gestaltet werden. Durch eine funktionale Erweiterung der Projektierungssoftware kann bei dem Anwender eine zusätzliche Produktivitätssteigerung erfolgen.

Durch ein einmaliges Abscannen der gesamten im Schaltschrank 1 eingebauten Geräte 3 nach Fertigstellung des Schaltschranks 1 können insbesondere folgende Produktivitätssteigerungen erreichen:
- Automatischer Abgleich zwischen Schaltschrank-Soll-Stückliste und Schaltschrank-Ist-Stückliste sowie entsprechender Fehlermeldung im Fehlerfall durch das Engineering Tool (die Projektierungssoftware). Hierdurch kann ein ordnungsgemäßer Schaltschrankeinbau kontrolliert werden.
- Automatische Stücklistenerstellung (Schaltschrank-Ist-Stückliste) durch das Engineering Tool. Das manuelle Abschreiben kann entfallen.
- Automatische Dokumentation der Schaltschrankkonfiguration auf Unikatsebene. Ein Gewährleistungsanspruch kann beispielsweise durch eine eindeutige Dokumentation der Schaltschrankkonfiguration verbessert geregelt werden, da durch die Dokumentation kontrolliert werden kann, ob ein Endkunde die Schaltschrankkonfiguration unerlaubt geändert hat.
- Automatische retrograde Lagerabbuchung der verbauten Komponenten durch das Engineering Tool.

## Patentansprüche

1. Verfahren zum Ermitteln von Geräteinformationen von in einem Schaltschrank (1) eingebauten Geräten (3), wobei mindestens zwei Geräte (3) in dem Schaltschrank (1) eingebaut sind, welche jeweils einen maschinenlesbaren Code (4) aufweisen, wobei der maschinenlesbare Code (4) eine Geräteinformation des jeweiligen Geräts (3) abbildet, mit folgenden Schritten:
- Auslesen der Geräteinformationen aus den Codes (4) der mindestens zwei eingebauten Geräte (3) und Hinterlegen der ausgelesenen Geräteinformationen in einem Speicher.

2. Verfahren nach Anspruch 1, wobei zumindest ein Teil der Geräteinformation des Geräts (3) eine Geräteseriennummer, ein Gerätemodell und/oder eine Fertigungsidentifikation des jeweiligen Geräts abbildet.

3. Verfahren nach einem der vorhergehenden Ansprüche, wobei das Verfahren ferner folgenden Schritt umfasst:
- Ausgeben mindestens eines Teils der hinterlegten Geräteinformationen über ein Ausgabemittel.

4. Verfahren nach Anspruch 3, wobei anhand der im Speicher hinterlegten Geräteinformationen eine Schaltschrank-Ist-Stückliste gebildet wird, welche über das Ausgabemittel ausgebbar ist.

5. Verfahren nach einem der Ansprüche 3 bis 4, wobei bei einem Entfernen eines eingebauten Gerätes (3), dessen Geräteinformation ausgelesen wurde, aus dem Schaltschrank (1) mindestens ein Teil der Geräteinformation des entfernten Gerätes (3) über das Ausgabemittel ausgegeben wird.

6. Verfahren nach einem der vorhergehenden Ansprüche, wobei das Verfahren ferner folgenden Schritt umfasst:
- Vergleichen mindestens eines Teils der hinterlegten Geräteinformationen mit mindestens einem Referenzwert.

7. Verfahren nach einem der vorhergehenden Ansprüche, wobei anhand der hinterlegten Geräteinformationen eine Schaltschrank-Ist-Stückliste gebildet wird, wobei die Schaltschrank-Ist-Stückliste mit einer Schaltschrank-Soll-Stückliste verglichen wird und ein Signal ausgegeben wird, sofern die Schaltschrank-Ist-Stückliste nicht mit der Schaltschrank-Soll-Stückliste übereinstimmt.

8. Verfahren nach einem der vorhergehenden Ansprüche, wobei bei einem Austauschen eines alten eingebauten Gerätes (3), dessen Geräteinformationen ausgelesen wurden, mit einem neuen Gerät (3), welches einen maschinenlesbaren Code (4) aufweist, die Geräteinformation aus dem Code des neuen eingebauten Gerätes ausgelesen wird und mit der hinterlegten Geräteinformation des alten ausgetauschten Gerätes (3) verglichen wird.

9. Verfahren nach einem der vorhergehenden Ansprüche, wobei die mindestens zwei Geräte (3) jeweils elektrische Schaltgeräte sind.

10. Verfahren nach einem der vorhergehenden Ansprüche, wobei der maschinenlesbare Code (4) insbesondere ein RFID Transponder, ein 1D Barcode oder ein 2D Barcode ist.

11. Verfahren nach einem der vorhergehenden Ansprüche, wobei die Geräteinformationen der maschinenlesbaren Codes (4) durch ein Lesegerät ausgelesen werden.

12. Verfahren nach Anspruch 11, wobei der Schaltschrank (1) das Lesegerät umfasst.

13. Verfahren nach einem der vorhergehenden Ansprüche, wobei eine Recheneinheit den Speicher umfasst.

14. System umfassend ein Lesegerät, einen Schaltschrank (1), mindestens zwei Geräte (3), welche jeweils einen maschinenlesbaren Code (4) aufweisen und in dem Schaltschrank (1) eingebaut sind, ein Ausgabemittel und eine Recheneinheit, wobei das System dazu ausgebildet ist das Verfahren nach einem der Ansprüche 1 bis 13 durchzuführen.

15. Computerprogrammprodukt enthaltend Programmcodemittel zur Ausführung eines Verfahrens nach einem der Ansprüche 1 bis 13, wenn besagtes Computerprogrammprodukt auf einem Datenverarbeitungssystem ausgeführt wird.
